# FASCICULE DE BREVET EUROPEEN

(11) **EP 1 169 760 B1**
(45) Date de publication et mention de la délivrance du brevet: **14.08.2002**
(21) Numéro de dépôt: 00908896.4
(22) Date de dépôt: 20.03.2000
(51) Int. Cl.: H01S 5/34

(54) **LASER SEMI-CONDUCTEUR INFRAROUGE**
HALBLEITERLASER FÜR DEN INFRAROTEN WELLENLÄNGENBEREICH
INFRARED SEMICONDUCTOR LASER

(30) Priorité: 25.03.1999 FR 9903845
(43) Date de publication de la demande: 09.01.2002
(73) Titulaire: Alpes Lasers SA, 2000 Neuchâtel (CH)
(72) Inventeur: MULLER, Antoine, CH-2000 Neuchâtel (CH); BECK, Mattias, CH-2000 Neuchâtel (CH); FAIST, Jérôme, CH-2000 Neuchâtel (CH); HOFSTETTER, Daniel, CH-2000 Neuchâtel (CH)
(74) Mandataire: Gresset, Jean
(86) Numéro de dépôt international: CH0000159
(87) Numéro de publication internationale: WO0059085

(56) Documents cités:
- EP-A- 0 877 454
- US-A- 5 818 066
- US-A- 5 818 861
- GMACHL C ET AL: "CONTINUOUS-WAVE AND HIGH-POWER PULSED OPERATION OF INDEX-COUPLED DISTRIBUTED FEEDBACK QUANTUM CASCADE LASER AT LAMBDA=8.5 MUM" APPLIED PHYSICS LETTERS,US,AMERICAN INSTITUTE OF PHYSICS. NEW YORK, vol. 72, no. 12, 23 mars 1998 (1998-03-23), pages 1430-1432, XP000742875 ISSN: 0003-6951
- PATENT ABSTRACTS OF JAPAN vol. 1996, no. 08, 30 août 1996 (1996-08-30) -& JP 08 088440 A (NIPPON TELEGR &TELEPH CORP <NTT>), 2 avril 1996 (1996-04-02)
- SIRTORI C ET AL: "LONG-WAVELENGTH (LAMBDA = 8-11.5 MUM) SEMICONDUCTOR LASERS WITH WAVEGUIDES BASED ON SURFACE PLASMONS" OPTICS LETTERS,US,OPTICAL SOCIETY OF AMERICA, WASHINGTON, vol. 23, no. 17, 1 septembre 1998 (1998-09-01), pages 1366-1368, XP000783339 ISSN: 0146-9592

## Description

La présente invention se rapporte aux lasers de type semi-conducteur émettant dans une bande de longueurs d'onde comprise dans l'infrarouge. De tels lasers, appelés plus simplement lasers infrarouges, ont fait l'objet de nombreuses publications et de plusieurs dépôts de brevets.

Il est entendu que les définitions des termes techniques et scientifiques utilisés et la plupart des phénomènes physiques mentionnés dans le présent document sont expliqués dans l'ouvrage intitulé "Quantum electronics" de Amnon Yariv, éditions J. Wiley, New-York 1989.

La présente invention concerne, plus particulièrement, un laser semi-conducteur infrarouge, du type comportant, de manière connue, une électrode inférieure et, sur celle-ci, un empilement de couches en matériau semi-conducteur qui forment un guide d'onde comprenant une région de gain, elle-même comprenant au moins :
- une zone active avec au moins un puits quantique permettant des transitions inter-sous-bandes de porteurs de charge susceptibles de générer un mode de lumière cohérente, et
- une zone d'injection attenante à la zone active.

Des lasers de ce type sont décrits dans un article de la revue Science, May 1997, Volume 75, pp. 773-776, intitulé "High-Power Infrared (8-Micrometer Wavelength) Supperlattice Lasers" et dans le document EP 0877 454. Ils sont de type unipolaire. Cela signifie que l'émission de photons fait appel à des porteurs de charge d'un seul type, en général des électrons.
Ces lasers comportent un substrat sur lequel on dépose des couches alternées de deux semi-conducteurs, constituant respectivement des puits et des barrières quantiques et formant au moins une zone active dans laquelle s'effectuent les transitions inter-sous-bandes, et une zone d'injection permettant d'injecter des électrons dans la zone active. Celle-ci est agencée de manière à comporter deux sous-bandes entre lesquelles les électrons peuvent transiter, le passage de la sous-bande supérieure à la sous-bande inférieure générant des photons de lumière cohérente.

La région de gain est interposée entre deux couches de confinement, l'une supérieure, l'autre inférieure, réalisées en un matériau à haut indice de réfraction et formant avec elle un guide d'onde. Celui-ci est adjacent à deux manteaux optiques, appelés aussi «claddings», à faible indice de réfraction, dont la fonction est d'empêcher la lumière de sortir des faces supérieure et inférieure du guide d'onde.

L'injection des électrons se fait au moyen d'électrodes, l'une inférieure, formée par le substrat, l'autre supérieure, formée par une couche métallique disposée sur l'empilement, toutes deux adjacentes à l'un des manteaux optiques. Ces électrodes ne participent pas au système optique du laser.

Une telle structure est complexe et les nombreuses interfaces entre les couches affectent le rendement du laser.

La présente invention a pour but de réaliser un laser semi-conducteur du type à puits quantique qui permet, dans sa zone active, des transitions inter-sous-bandes et qui présente une structure simple et un rendement amélioré.

Ce laser est caractérisé en ce que l'empilement de couches comporte, dans sa partie opposée à l'électrode inférieure, une couche semi-conductrice attenante à la région de gain et rendue conductrice par dopage de manière à constituer une électrode supérieure coopérant avec l'électrode inférieure pour soumettre la région de gain à un champ électrique et en ce que la partie de l'électrode supérieure au-dessus de la région de gain est, avec son côté opposé à l'électrode inférieure, en contact direct avec l'environnement de l'empilement du laser.

De la sorte, il n'est plus nécessaire de placer un manteau au-dessus du guide d'onde, l'air ou le vide en tenant lieu. Avec une telle structure, il -est possible que le mode de lumière cohérente pénètre dans l'environnement de l'empilement, du côté opposé à l'électrode inférieure. Les essais ont montrés qu'une pénétration d'au moins 0.5 ‰ était particulièrement favorable.

Selon l'épaisseur de la région active, il est nécessaire ou souhaitable que le guide comporte des couches de confinement, l'une supérieure, l'autre inférieure, entre lesquelles la région de gain est interposée, afin d'obtenir un couplage optimum. La couche de confinement supérieure est en contact direct avec l'air ou le vide entourant le laser, qui définit alors le manteau supérieure.

Selon un mode préféré de réalisation, l'électrode supérieure est formée par dopage dans la couche de confinement supérieure.

Un tel laser est généralement fabriqués par croissance épitaxiale, puis par attaque chimique. De ce fait, l'empilement des couches formant la région de gain et la couche de confinement supérieure constitue un prisme de section trapézoïdale dont la grande base est définie par la face inférieure de la région de gain et dont la petite base est définie par la face supérieure de la couche de confinement supérieure.

De façon avantageuse, le laser selon l'invention comporte, en outre:
- une couche isolante recouvrant les portions latérales de la couche de confinement inférieure ainsi que les côtés inclinés du prisme, et
- une couche conductrice recouvrant ladite couche isolante et débordant légèrement sur les côtés de l'électrode supérieure pour lui servir de liaison électrique avec une source d'alimentation.

Le laser selon la présente invention trouve des applications particulièrement intéressantes dans le domaine de la spectroscopie, du fait que les lignes d'absorption de la plupart des molécules gazeuses sont précisément situées dans sa bande de longueurs d'onde.

Lorsque ces lasers sont activés par injection de courant sous forme de brèves impulsions, ce qui est nécessaire pour les faire fonctionner à une température proche de l'ambiante, ils présentent un large spectre d'émission, pouvant atteindre 10 cm⁻¹. Or, les gaz à pression ambiante ont des raies d'absorption dont la largeur est d'environ 0.1 cm⁻¹. Pour réduire la largeur du spectre d'émission de tels lasers, il a été proposé de définir, à l'intérieur de la couche de confinement et du manteau supérieur, un réseau d'interférence qui force un mode particulier. Une solution de ce type est décrite dans l'ouvrage intitulé "Quantum Electronics" mentionné ci-dessus, au chapitre 22.4. Le manteau optique supérieur et la couche de confinement présentent alors des découpes, pratiquées par lithographie et obturées par un métal, par exemple de l'or. Ces découpes définissent un réseau d'interférence dont le pas est égal à un multiple de la moitié de la longueur d'onde désirée. Dans ce cas, le mode sélectionné est forcé par absorption.

Selon une autre solution, décrite, par exemple, dans l'ouvrage intitulé "Optoélectronique" de E. Rosencher et B. Masson, chap. 13, Paris 1998, le métal est remplacé par un diélectrique. Le mode sélectionné est alors forcé par un phénomène physique faisant appel à la réflexion. L'électrode est disposée au-dessus du diélectrique.

Malheureusement, dans un cas comme dans l'autre, le rétrécissement du spectre d'émission conduit à une diminution importante du rendement.

L'un des buts essentiels de la présente invention est de réaliser un laser semi-conducteur infrarouge qui dispose d'un guide d'onde permettant à la fois un fort couplage avec le réseau, de faibles pertes optiques et une simplification dans le processus de fabrication.

Ce but est atteint grâce au fait que la couche de confinement supérieure présente une structure constituant un réseau de diffraction de pas égal à un multiple de la moitié de la longueur d'onde désirée du spectre d'émission du laser.

Comme l'électrode fait partie intégrante de la couche de confinement supérieure, celle-ci est adjacente au gaz ou au vide, de sorte que les conditions à la limite sont optimales, l'indice de réfraction étant minimum.

Ainsi, l'utilisation d'une électrode supérieure en un matériau semi-conducteur transparent et dopé permet d'améliorer considérablement les caractéristiques du laser, bien que la résistivité soit sensiblement plus élevée que celle d'un métal. En d'autres termes, malgré les pertes par effet Joule, le rendement est nettement meilleur.

Le laser selon l'invention présente encore les caractéristiques suivantes:
- l'électrode inférieure constitue un substrat et est réalisée en phosphure d'indium dopé au silicium;
- les couches de confinement inférieure et supérieure sont réalisées en un alliage d'arséniure d'indium et de gallium;
- la partie de la couche de confinement supérieure rendue conductrice l'est par dopage au silicium;
- la couche formant la région de gain est formée d'une succession de couches d'arséniure d'aluminium et d'indium et d'arséniure d'indium et de gallium;
- la couche isolante est réalisée en séléniure de zinc;
- la couche conductrice est réalisée en un alliage d'or et/ou de titane.

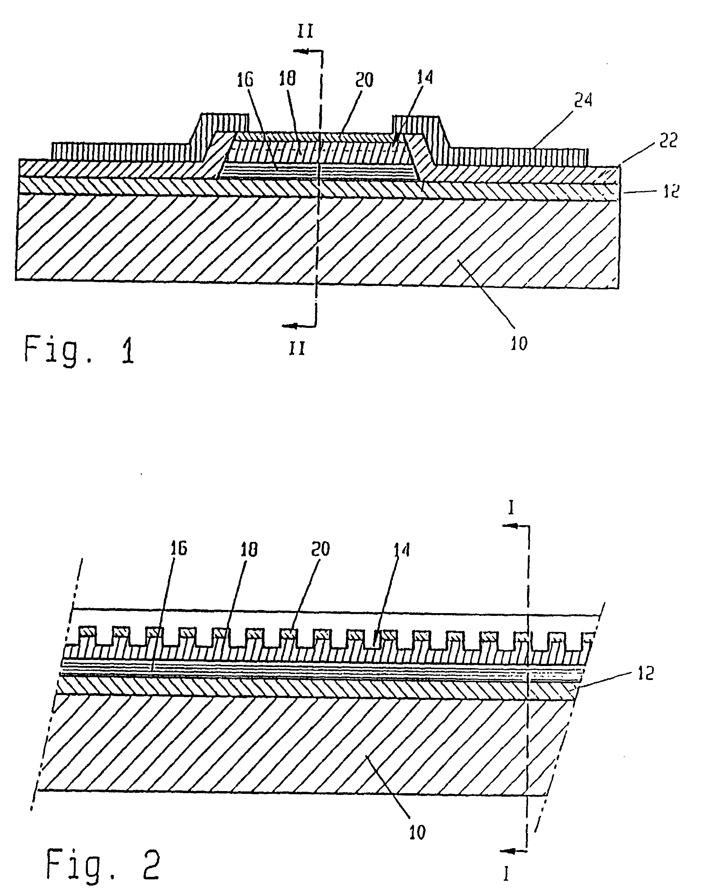

D'autres avantages et caractéristiques de l'invention ressortiront de la description qui va suivre, faite en regard du dessin annexé, dans lequel les figures 1 et 2 montrent, en coupes, orthogonales l'une à l'autre, un laser selon l'invention.

Ainsi qu'on peut le voir sur le dessin, le laser selon l'invention comporte un substrat 10, en phosphure d'indium (InP), dopé au silicium (Si: 2 x 10¹⁷cm⁻³) qui, du point de vue optique, forme un manteau optique inférieur et, du point de vue électrique, tient lieu d'électrode inférieure. Ce substrat est-revêtu d'une couche transparente 12 d'un alliage d'arséniure d'indium et de gallium (InGaAs) constituant une couche de confinement inférieure.

La couche 12 porte, dans sa partie médiane, un empilement 14 de forme prismatique à section trapézoïdale fait de trois couches semi-conductrices portant les références 16, 18 et 20. Plus précisément, la grande base du trapèze est définie par la face inférieure de la couche 16, tandis que sa petite base est définie par la face supérieure de la couche 20.

La couche inférieure 16 est une région active formée elle-même d'une succession de couches d'arséniure d'aluminium et d'indium (AlInAs) et d'arséniure d'indium et de gallium (InGaAs) qui constituent respectivement des barrières et des puits quantiques

La couche intermédiaire 18 et la couche supérieure 20 sont toutes deux également en arséniure d'indium et de gallium (InGaAs) rendu conducteur par dopage au silicium. Les couches 18 et 20 se distinguent l'une de l'autre par le fait qu'elles sont respectivement dopées à des taux de 2.10¹⁸ et 5.10¹⁹ cm⁻³ et présentent des épaisseurs de 500 et 10 nm.

La couche supérieure 20 fait office d'électrode supérieure. Par ailleurs, elle forme avec la couche intermédiaire 18, sensiblement plus épaisse, une couche de confinement dont l'indice de réfraction est très élevé, puisqu'il. atteint 3.2. Comme la couche de confinement se trouve au sommet de l'empilement, son environnement, soit l'air ambiant, présente un indice de réfraction égal à 1. Il n'est, de la sorte, pas nécessaire de disposer un manteau optique supérieur, l'air en tenant lieu.

Avec une telle structure, le mode généré pénètre dans l'air se trouvant au-dessus de l'empilement 14. Des conditions de travail particulièrement bonnes sont obtenues lorsque le mode pénètre d'au moins 0.5‰.

Les couches de confinement, formées des couches 12, 18 et 20, constituent, avec la région active 16, un guide d'onde dans laquelle la lumière générée par l'effet laser est confinée.

On relèvera que si la région active est suffisamment épaisse pour assurer un bon couplage du mode, les couches de confinement peuvent être considérablement réduites, voire supprimées. II ne subsistera alors que la couche 20, en matériau semi-conducteur dopé, qui forme l'électrode supérieure.

Les portions latérales. de la couche de confinement inférieure 12 qui ne reçoivent pas l'empilement 14 ainsi que les côtés inclinés du prisme sont recouverts d'une couche 22 isolante en séléniure de zinc (ZnSe). Celle-ci est, elle-même, revêtue d'une couche conductrice 24, en alliage d'or et/ou de titane (Ti/Au), qui déborde légèrement sur les côtés de l'électrode supérieure 20 et constitue ainsi une liaison électrique permettant de la connecter, comme l'électrode inférieure 10, à une source de courant non représentée.

Comme le montre la figure 2, un réseau en créneaux est pratiqué dans les deux couches 18 et 20, par photolithographie, avec des creux de 300 nm environ. Plus précisément, le réseau est formé d'une alternance de creux et de protubérances, dont le pas p est égal à 1,6 µm, avec une largeur des creux sensiblement égale à celle des protubérances. Ce pas permet de forcer, dans le guide d'onde, une longueur d'onde égale à 3.2 µm. Comme l'indice de réfraction y est sensiblement égale à 3.2, la longueur d'onde dans l'air vaut donc 10.2 µm.

La structure de l'empilement 14 est décrite de manière plus détaillée dans la demande de brevet FR 98 15721 (FR 2 787 246 A) au nom de la demanderesse.

Un laser de ce type a été fabriqué, avec une région active formée d'une succession de couches de AllnAs et de InGaAs dont les épaisseurs en nm, écrites respectivement en caractères gras en caractères maigres, sont les suivantes: 3.9/**1.0**/3.8/**1.2**/3.7/**1.5**/3.9/**1.7**/4.0/**4.2**/3.1/**0.9**/6.4/**1.0**/6.0/**2.8**. On notera que les couches soulignées sont dopées au Si, avec une densité égale à 2.5.10¹⁷ cm⁻³.

Ce laser a une longueur d'environ 1.5 mm et une largeur (dimension de la grande base) de 40 µm. La couche 24 a été réalisée au moyen d'une sous-couche de titane de 10 nm et d'une couche d'or de 400 nm. Elle déborde de 5 µm sur la couche 20.

L'alimentation d'un tel laser nécessite l'application d'une tension entre les électrodes 10 et 20, sous forme d'impulsions de 200 ns environ, à une fréquence de 80 kHz par exemple.

A basse température (80 K), le laser présente un seuil de courant à 1 A et une puissance maximum de sortie de 230 mW pour une tension de 9.7 V. Son rendement est de 220 mW/A et la densité de seuil de courant de 1.85 kA/cm². A la température ambiante, sa puissance de sortie est encore de 80 mW, avec un rendement de 80 mW/A. Le seuil de courant est alors passé à 3 A (densité de seuil de courant égale à 5.5 kA/cm²) pour une tension d'alimentation de 12.5 V.

## Revendications

1. Laser semi-conducteur infrarouge comportant une électrode inférieure (10) et, sur celle-ci, un empilement (14) de couches en matériau semi-conducteur qui forment un guide d'onde comprenant une région de gain (16), elle-même comprenant au moins :
- une zone active avec au moins un puits quantique permettant des transitions inter-sous-bandes de porteurs de charge susceptibles de générer un mode de lumière cohérente, et
- une zone d'injection attenante à la zone active,
**caractérisé en ce que** ledit empilement (14) comporte, dans sa partie opposée à ladite électrode inférieure (10), une couche semi-conductrice (20) attenante à la région de gain (16) et rendue conductrice par dopage de manière à constituer une électrode supérieure coopérant avec l'électrode inférieure pour soumettre la région de gain (16) à un champ électrique et **en ce que** la partie de l'électrode supérieure au-dessus de la région de gain est, avec son côté opposé à l'électrode inférieure (10), en contact direct avec l'environnement de l'empilement (14) du laser.

2. Laser selon la revendication 1, **caractérisé en ce que** ledit mode pénètre d'au moins 0.5 ‰ dans l'environnement de l'empilement, du côté opposé à l'électrode inférieure.

3. Laser selon l'une des revendications 1 et 2, **caractérisé en ce que** ledit guide d'onde comporte, en outre, deux couches de confinement, l'une supérieure(18, 20), l'autre inférieure (12), entre lesquelles la région de gain (16) est interposée.

4. Laser selon la revendication 3, **caractérisé en ce que** ladite électrode supérieure (20) est formée par dopage dans la couche de confinement supérieure (18, 20).

5. Laser selon l'une des revendications 3 et 4, **caractérisé en ce que** l'empilement des couches formant la région de gain (16) et la couche de confinement supérieure (18, 20) constitue un prisme de section trapézoïdale (14) dont la grande base est définie par la face inférieure de la région de gain et dont la petite base est définie par la face supérieure de la couche de confinement supérieure.

6. Laser selon la revendication 5, **caractérisé en ce qu'**il comporte, en outre:
- une couche isolante (22) recouvrant les portions latérales de la couche de confinement inférieure (12) ainsi que les côtés inclinés du prisme, et
- une couche conductrice (24) recouvrant ladite couche isolante et débordant légèrement sur les côtés de l'électrode supérieure (20) pour lui servir de liaison électrique avec une source d'alimentation.

7. Laser selon l'une des revendications 3 à 6, **caractérisé en ce que** la couche de confinement supérieure présente une structure définissant un réseau de diffraction de pas égal à un multiple de la moitié d'une longueur d'onde désirée de son spectre d'émission.

8. Laser selon l'une des revendications 3 à 7, **caractérisé en ce que** l'électrode inférieure (10) constitue un substrat et est réalisée en phosphure d'indium dopé au silicium.

9. Laser selon l'une des revendications 3 à 8, **caractérisé en ce que** les couches de confinement inférieure (12) et supérieure (18, 20) sont réalisées en un alliage d'arséniure d'indium et de gallium.

10. Laser selon la revendication 9, **caractérisé en ce que** la partie de la couche de confinement supérieure rendue conductrice l'est par dopage au silicium.

11. Laser selon l'une des revendications 1 à 10, **caractérisé en ce que** la couche formant la région de gain (16) est formée d'une succession de couches d'arséniure d'aluminium et d'indium et d'arséniure d'indium et de gallium.

12. Laser selon la revendication 6, **caractérisé en ce que** ladite couche isolante (22) est réalisée en séléniure de zinc.

13. Laser selon la revendication 6, **caractérisé en ce que** ladite couche conductrice (24) est réalisée en un alliage d'or et/ou de titane.

## Claims

1. Infrared semiconductor laser including a bottom electrode (10) and, thereon, a stack (14) of layers of semiconductor material which form a waveguide including a gain region (16) itself including at least:
- an active zone with at least a quantum well to enable transitions between the subbands of current carriers capable of generating a coherent lighting mode, and
- an injection zone adjacent to the active zone,
**characterised in that** said stack (14) includes, in its part opposite said electrode (10), a layer (20) adjacent to the gain region (16) which is made conductive by doping so as to form a top electrode co-operating with the bottom electrode to subject the gain region (16) to an electric field.

2. Laser according to claim 1, **characterised in that** said mode penetrates by at least 0.5% the environment of the stack, on the opposite side to the bottom electrode.

3. Laser according to claims 1 and 2, **characterised in that** said waveguide further includes two confinement layers, an upper layer (18, 20) and a lower layer (12), between which the gain region (16) is inserted.

4. Laser according to claim 3, **characterised in that** said top electrode (20) is formed by doping the upper confinement layer (18, 20).

5. Laser according to claims 3 and 4, **characterised in that** the stack of layers forming the gain region (16) and the upper confinement layer (18, 20) form a prism of trapezoid cross-section (14) the large base of which is defined by the bottom face of the gain region and the small base of which is defined by the top face of the upper confinement layer.

6. Laser according to claim 5, **characterised in that** it further includes:
- an insulating layer (22) covering the lateral portions of the lower confinement layer (12) and the inclined sides of the prism, and
- a conductive layer (24) covering said insulating layer and slightly overlapping onto the sides of the top electrode (20) to act as an electric connection therefor with a power source.

7. Laser according to any of claims 3 to 6, **characterised in that** the upper confinement layer has a structure defining a diffraction network whose pitch is equal to a multiple of half of a desired wavelength of its emission spectrum.

8. Laser according to any of claims 3 to 7, **characterised in that** the bottom electrode (10) forms a substrate and is made of silicon doped indium phosphide.

9. Laser according to any of claims 3 to 8, **characterised in that** the lower (12) and upper (18, 20) confinement layers are made of an indium arsenide gallium alloy.

10. Laser according to claim 9, **characterised in that** the part of the upper confinement layer made conductive is made so by silicon doping.

11. Laser according to any of claims 1 to 10, **characterised in that** the layer forming the gain region (16) is formed of a succession of layers of aluminium indium arsenide and indium gallium arsenide.

12. Laser according to claim 6, **characterised in that** said insulating layer (22) is made of zinc selenide.

13. Laser according to claim 6, **characterised in that** said conductive layer (24) is made of a gold and/or titanium alloy.

## Patentansprüche

1. Halbleitender Infrarotlaser mit einer Unterelektrode (10) und auf dieser einem Stapel (14) aus Schichten aus halbleitendem Material, die einen Wellenleiter bilden, mit einem Verstärkungsbereich (16), zu dem mindestens:
- Ein aktiver Bereich mit mindestens einem Quantenwell gehört, der Intersubband-Übergänge von Ladungsträgern ermöglicht, die einen kohärenten Lichtmodus erzeugen können,
- Und eine an die aktive Zone angrenzende Injektionszone gehört,
**dadurch gekennzeichnet, dass** der Stapel (14) in seinem Teil, der der Unterelektrode (10) gegenüber liegt, mit einer halbleitenden Schicht (20) versehen ist, die an den Verstärkungsbereich (16) angrenzt und durch Dotierung in der Form leitend gemacht ist, dass sie eine Oberelektrode bildet, die mit der Unterelektrode zusammenarbeitet, um den Verstärkungsbereich (16) einem elektrischen Feld zu unterwerfen und **dadurch gekennzeichnet, dass** der Teil der Oberelektrode, der oberhalb des Verstärkungsbereiches liegt, mit seiner Seite, die der Unterelektrode (10) gegenüber liegt, in direktem Kontakt zu dem Umfeld des Stapels (14) des Lasers steht.

2. Laser nach Anspruch 1, **dadurch gekennzeichnet, dass** besagter Modus mit mindestens 0,5 ‰ in das Umfeld des Stapels eindringt und zwar auf der Seite, die der Unterelektrode gegenüber liegt.

3. Laser nach einem der Ansprüche 1 und 2, **dadurch gekennzeichnet, dass** der Wellenleiter unter anderem über zwei Einschlussschichten verfügt, eine obere (18, 20) und eine untere (12), zwischen denen der Verstärkungsbereich (16) eingeschlossen ist.

4. Laser nach Anspruch 3, **dadurch gekennzeichnet, dass** die Oberelektrode (20) über Dotierung in der oberen Einschlussschicht (18, 20) gebildet wird.

5. Laser nach einem der Ansprüche 3 und 4, **dadurch gekennzeichnet, dass** der Stapel aus Schichten, der den Verstärkungsbereich (16) und die obere Einschlussschicht (18, 20) bildet, ein trapezförmiges Sektionsprisma (14) bildet, dessen große Grundfläche von der Unterseite des Verstärkungsbereiches und die kleine Deckfläche von der Oberseite der oberen Einschlussschicht abgegrenzt werden.

6. Laser nach Anspruch 5, **dadurch gekennzeichnet, dass** er unter anderem:
- Eine isolierende Schicht (22) umfasst, die die seitlichen Anteile der unteren Einschlussschicht (12) und die geneigten Seiten des Prismas bedeckt, und
- Eine leitende Schicht (24) hat, die die isolierende Schicht bedeckt und leicht über die Seiten der Oberelektrode (20) hinausgeht, um für diese die Funktion der elektrischen Anbindung an eine Speisungsquelle zu übernehmen.

7. Laser nach einem der Ansprüche 3 bis 6, **dadurch gekennzeichnet, dass** die obere Einschlussschicht eine Struktur aufweist, die ein Beugungsgitter von Schritten bildet, die einem Vielfachen der Hälfte einer Wellenlänge entsprechen, die für das Emissionsspektrum gewünscht wird.

8. Laser nach einem der Ansprüche 3 bis 7, **dadurch gekennzeichnet, dass** die Unterelektrode (10) ein Substrat bildet und aus mit Silizium versetzten Indiumphosphid besteht.

9. Laser nach einem der Ansprüche 3 bis 8, **dadurch gekennzeichnet, dass** die untere (12) und obere (18, 20) Einschlussschicht aus einer Legierung aus Indiumarsenid und Gallium bestehen.

10. Laser nach Anspruch 9, **dadurch gekennzeichnet, dass** der Teil der oberen Einschlussschicht, der leitend ist, dies aufgrund der Dotierung mit Silizium ist.

11. Laser nach einem der Ansprüche 1 bis 10, **dadurch gekennzeichnet, dass** die Schicht, die den Verstärkungsbereich (16) bildet, aus einer Aufeinanderfolge von Schichten aus Aluminiumarsenid und Indium und Indiumarsenid und Gallium besteht.

12. Laser nach Anspruch 6, **dadurch gekennzeichnet, dass** die isolierende Schicht (22) aus Zinkselenid besteht.

13. Laser nach Anspruch 6, **dadurch gekennzeichnet, dass** die leitende Schicht (24) aus einer Gold- und/oder Titanlegierung besteht.
